# EUROPEAN PATENT APPLICATION

(11) **EP 4 819 812 A1**
(43) Date of publication of application: **07.10.2026**
(21) Application number: 25847176.2
(22) Date of filing: 28.07.2025
(51) Int. Cl.: H10K 59/35, H10K 59/38, H10K 59/80

(54) **DISPLAY PANEL, DISPLAY DEVICE, AND VEHICLE**

(30) Priority: 02.08.2024 CN 202411061536
(71) Applicant: Hubei Yangtze Industrial Innovation Center of Advanced Display Co., Ltd., East Lake Hi-tech Development Zone Wuhan, Hubei 430074 (CN)
(72) Inventor: CAI, Yu, Wuhan, Hubei 430074 (CN)
(74) Representative: Boult Wade Tennant LLP
(86) International application number: PCT/CN2025/111028
(87) International publication number: WO 2026/026743

(57) **Abstract**

The present application provides a display panel, a display device, and a vehicle. The display panel comprises a first-type pixel and a second-type pixel. The light emission viewing angle range of the second-type pixel is greater than that of the first-type pixel. The first-type pixel comprises a first sub-pixel of a first color, and the second-type pixel comprises a second sub-pixel of the first color. The display panel further comprises a substrate and a light regulation structure. The first-type pixel and the second-type pixel are arranged on one side of the substrate, and the light regulation structure is at least partially arranged on the side of the first-type pixel distant from the substrate. The orthographic projection area of the second sub-pixel on the substrate is greater than that of the first sub-pixel on the substrate, and the light emission efficiency of the first sub-pixel is greater than that of the second sub-pixel.

## Description

### CROSS-REFERENCE TO RELATED APPLICATION

The present application claims priority to Chinese Patent Application No. 202411061536.4 filed on August 2, 2024, and titled "DISPLAY PANEL, DISPLAY DEVICE, AND VEHICLE", which is incorporated herein by reference in its entirety.

### TECHNICAL FIELD

The present application relates to the technical field of display devices, and in particular to a display panel, a display device and a vehicle.

### BACKGROUND

With the development of science and technology, the field of display panels has also made great progress and achieved diversified development. On this basis, people's requirements for display panels are also increasing day by day. For example, people's demand for anti-peeping and other technologies is gradually increasing.

### SUMMARY

The embodiments of present application provide a display panel, a display device, and a vehicle, which can improve the viewing experience of the display panel.

In a first aspect, the embodiments of the present application provide a display panel, comprising a first type of pixels and a second type of pixels, a light-emitting viewing angle range of the second type of pixels being greater than a light-emitting viewing angle range of the first type of pixels, the first type of pixels comprising a first sub-pixel of a first color, and the second type of pixels comprising a second sub-pixel of the first color.

The display panel further comprises a substrate and a dimming structure, the first type of pixels and the second type of pixels are provided on a side of the substrate, and the dimming structure is at least partially provided on a side of the first type of pixels facing away from the substrate, wherein an orthographic projection area on the substrate of the second sub-pixel is larger than an orthographic projection area on the substrate of the first sub-pixel, and a light extracting efficiency of the first sub-pixel is greater than a light extracting efficiency of the second sub-pixel.

In a second aspect, embodiments of the present application provide a display device, comprising a display panel according to any one of the aforementioned embodiments.

In a third aspect, embodiments of the present application provide a vehicle comprising a display device according to any one of the aforementioned embodiments.

Embodiments of the present application provide a display panel, a display device, and a vehicle. By setting the orthographic projection area on the substrate of the second sub-pixel to be larger than the orthographic projection area on the substrate of the first sub-pixel, the second sub-pixel can have a longer usage duration than the first sub-pixel, thereby improving the overall service life of the display panel. Furthermore, by adding the dimming structure, the light extracting efficiency of the first sub-pixel is made greater than the light extracting efficiency of the second sub-pixel, thereby reducing the display difference between the first sub-pixel and the second sub-pixel when emitting light, reducing the difference in display effects when the display panel switches between different modes, improving the user's corresponding viewing experience, and achieving a simultaneous improvement in service life and display effect.

### BRIEF DESCRIPTION OF THE DRAWINGS

In order to more clearly illustrate the technical solution of the embodiments of the present application, the following is a brief introduction to the drawings required for use in the embodiments of the present application. For those skilled in the art, other drawings can be obtained based on these drawings without any creative work.
Fig. 1 is a schematic diagram of a pixel arrangement of a display panel provided in an embodiment of the present application;
Fig. 2 is a schematic cross-sectional structural diagram at A-A in Fig. 1;
Fig. 3 is a schematic cross-sectional structural diagram of a display panel provided in another embodiment of the present application;
Fig. 4 is a schematic cross-sectional structural diagram of a display panel provided in another embodiment of the present application;
Fig. 5 is a schematic cross-sectional structural diagram of a display panel provided in another embodiment of the present application;
Fig. 6 is a schematic cross-sectional structural diagram of a display panel provided in another embodiment of the present application;
Fig. 7 is a schematic cross-sectional structural diagram of a display panel provided in another embodiment of the present application;
Fig. 8 is a schematic diagram of a pixel arrangement of a display panel provided in another embodiment of the present application;
Fig. 9 is a schematic diagram of a circuit structure of a display panel provided in another embodiment of the present application;
Figs. 10a to 10c are schematic diagrams of circuit timing of the circuit structure corresponding to Fig. 9 in different working modes;
Fig. 11 is a schematic structural diagram of a display device provided in an embodiment of the present application; and
Fig. 12 is a schematic structural diagram of a vehicle-mounted display in a vehicle provided in an embodiment of the present application.

### DETAILED DESCRIPTION

The features and exemplary embodiments of various aspects of the present application will be described in detail below. In order to make the purpose, technical solutions and advantages of the present application more clear, the present application will be further described in detail below in conjunction with the accompanying drawings and specific embodiments. It should be understood that the specific embodiments described here are only intended to explain the present application, rather than limit the present application. For those skilled in the art, the present application can be implemented without the need for some of these specific details. The following description of the embodiments is only to provide a better understanding of the present application by illustrating the examples of the present application.

It should be noted that, in this article, relational terms such as first and second are only used to distinguish one entity or operation from another entity or operation, and do not necessarily require or imply any such actual relationship or order between these entities or operations. Moreover, the terms "include", "comprise" or any other variants thereof are intended to cover non-exclusive inclusion, so that a process, method, article or device including a series of elements comprises not only those elements, but also other elements not explicitly listed, or also comprises elements inherent to such process, method, article or device. In the absence of further restrictions, the elements defined by the statement "comprise..." do not exclude the existence of other identical elements in the process, method, article or device comprising the elements.

Display panels can usually be used in a variety of fields and environments, and users have different requirements for display panels in different situations. In some cases, such as in the field of vehicle-mounted displays, in order to improve driving safety, it is usually necessary to control the light path of the display panel to achieve an anti-peeping effect, reduce the impact of the displayed image on the driver, and reduce the risk of causing safety hazards.

In the related art, in order to meet the anti-peeping requirements for the display panel, the display panel needs to be provided with two types of pixels: anti-peeping sub-pixels and normal sub-pixels (non-anti-peeping sub-pixels). The anti-peeping sub-pixels are used to realize the anti-peeping display of the display panel, and the normal sub-pixels are used to realize the wide-viewing angle display of the display panel. Due to factors such as service life, there are often differences in size, shape, and number between normal sub-pixels and anti-peeping sub-pixels. On this basis, the display panel often has different display effects when performing anti-peeping display and wide-viewing angle display, so it is likely to have an adverse impact on the user's viewing experience.

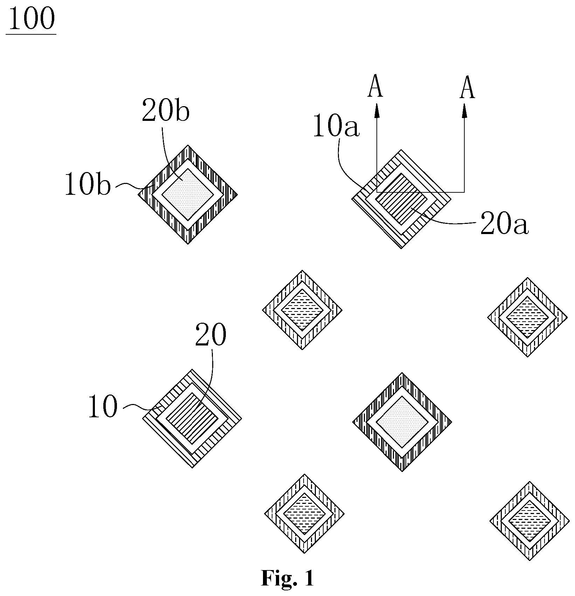

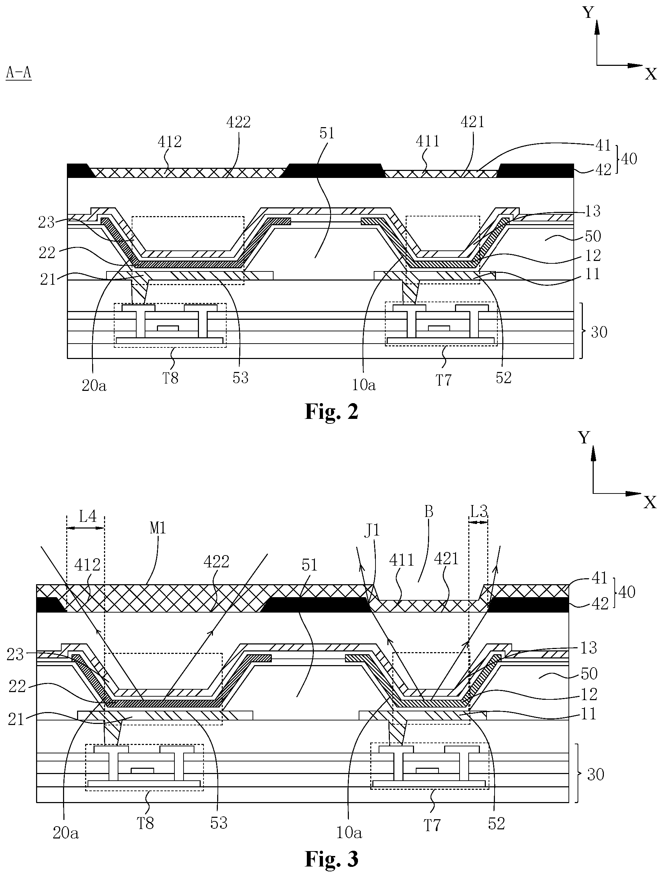

In response to the above problems, in a first aspect, referring to Figs. 1 and 2, an embodiment of the present application provides a display panel 100, comprising a first type of pixels 10 and a second type of pixels 20, a light-emitting viewing angle range of the second type of pixels 20 being greater than a light-emitting viewing angle range of the first type of pixels 10, the first type of pixels 10 comprising a first sub-pixel 10a of a first color, and the second type of pixels 20 comprising a second sub-pixel 20a of the first color.

The display panel 100 further comprises a substrate 30 and a dimming structure 40. The first type of pixels 10 and the second type of pixels 20 are provided on a side of the substrate 30, and the dimming structure 40 is at least partially provided on a side of the first type of pixels 10 facing away from the substrate 30. An orthographic projection area on the substrate 30 of the second sub-pixel 20a is larger than an orthographic projection area on the substrate 30 of the first sub-pixel 10a, and a light extracting efficiency of the first sub-pixel 10a is greater than a light extracting efficiency of the second sub-pixel 20a.

The first type of pixels 10 and the second type of pixels 20 are pixel structures with different functions, respectively, where the first type of pixels 10 and the second type of pixels 20 may both include a plurality of sub-pixels for emitting light of different colors, and the light-emitting color of at least some of the sub-pixels in the first type of pixels 10 may be the same as or different from the light-emitting color of at least some of the sub-pixels in the second type of pixels 20.

The first type of pixels 10 can be formed by stacking a variety of film layer structures. For example, the first type of pixels 10 can include an anode, a light-emitting portion and a cathode, the light-emitting portion being sandwiched between the anode and the cathode, and the anode and the cathode jointly driving the light-emitting portion under the action of their respective corresponding electrical signals to realize light-emitting display. Furthermore, the first type of pixels 10 can also include a pixel circuit corresponding to the light-emitting portion, which can realize the control of whether the first type of pixels 10 emit light or not. The same holds true for the second type of pixels 20, and the description thereof will not be repeated in embodiments of the present application.

It should be noted that the embodiments of the present application do not limit the specific functions of the first type of pixels 10 and the second type of pixels 20. For example, the display panel 100 may be an anti-peeping display panel 100, in which case the first type of pixels 10 may be sub-pixels in the display panel 100 for realizing an anti-peeping function, and the second type of pixels 20 may be sub-pixels in the display panel 100 for realizing a wide-viewing angle light-emitting function. Specifically, the first type of pixels 10 are sub-pixels in the display panel 100 that can realize a display function within a narrow viewing angle range, and the second type of pixels 20 are sub-pixels in the display panel 100 that can realize a display function within a wide viewing angle range, wherein the light-emitting viewing angle range of the first type of pixels 10 is within the light-emitting viewing angle range of the second type of pixels 20.

Alternatively, the display panel 100 may be a display panel 100 that displays different images at different viewing angles. In this case, the first type of pixels 10 may be sub-pixels in the display panel 100 that can realize a display function within a first viewing angle range, and the second type of pixels 20 may be sub-pixels in the display panel 100 that can realize a display function within a second viewing angle range. The first viewing angle range and the second viewing angle range at least partially do not overlap, and the light-emitting range corresponding to the first viewing angle range is smaller than the light-emitting range corresponding to the second viewing angle range. For the convenience of description, the embodiments of the present application are described below by taking the display panel 100 as an anti-peeping display panel 100, the first type of pixels 10 as anti-peeping sub-pixels, and the second type of pixels 20 as normal sub-pixels as an example.

The first type of pixels 10 comprise a first sub-pixel 10a, and the second type of pixels 20 comprise a second sub-pixel 20a. The first sub-pixel 10a and the second sub-pixel 20a are both of the first color, that is, the first sub-pixel 10a and the second sub-pixel 20a are configured to emit light of the same color. The specific color of the first color is not limited in the embodiment of the present application. Optionally, the first color can be one of red, green and blue.

In addition to the first type of pixels 10 and the second type of pixels 20, the display panel 100 further comprises a substrate 30 and a dimming structure 40. The substrate 30 mainly plays a role of supporting and bearing. Other film layer structures and device structures are stacked on the substrate 30 in sequence. "Stacked" mentioned here means that other film layer structures and device structures are sequentially provided along a thickness direction Y of the substrate 30. Here, the thickness direction Y of the substrate 30 is usually consistent with the thickness direction Y of other film layers. For the convenience of description, the thickness direction Y of the substrate 30 and the thickness direction Y of other film layers are schematically shown in the same direction in the embodiments of the present application.

The substrate 30 may generally include a plurality of film layer structures; for example, the substrate 30 may include a semiconductor layer and a plurality of conductor layers, and also an insulating layer(s) between two adjacent conductor layers or between a conductor layer and a semiconductor layer that are adjacent, all of which are stacked. Embodiments of the present application do not limit the specific film layers in the substrate 30. Optionally, the conductor structures in the conductor layers and the semiconductor structure in the semiconductor layer together constitute a pixel circuit, and a plurality of pixel circuits are provided corresponding to different first type of pixels 10 and second type of pixels 20 respectively to control whether the first type of pixels 10 or the second type of pixels 20 emit light or not.

The first type of pixels 10 and the second type of pixels 20 are located on the same side of the substrate 30, and the dimming structure 40 is provided at least partially on the side of the first type of pixels 10 facing away from the substrate 30, that is, the dimming structure 40 is located on the light-emitting side of the first type of pixels 10, and the orthographic projection on the substrate 30 of the dimming structure 40 overlaps with the orthographic projections on the substrate 30 of the first type of pixels 10. The dimming structure 40 is used at least to adjust a portion of the light rays emitted from the first type of pixels 10.

Embodiments of the present application do not limit the positional relationship of the dimming structure 40 and the second type of pixels 20. Optionally, the orthographic projection of the dimming structure 40 on the substrate 30 can overlap with the orthographic projections of the second type of pixels 20 on the substrate 30, so that the dimming structure 40 can adjust both a portion of the light emitted from the first type of pixels 10 and a portion of the light emitted from the second type of pixels 20. Alternatively, the orthographic projection of the dimming structure 40 on the substrate 30 can also be located outside the orthographic projections of the second type of pixels 20 on the substrate 30, that is, the dimming structure 40 can also only adjust a portion of the light emitted from the first type of pixels 10, but not a portion of the light emitted from the second type of pixels 20.

The dimming structure 40 can adjust the light in various ways. For example, the dimming structure 40 can include a filter, which can filter a portion of the light rays to adjust the color and brightness of the light emitted from the dimming structure 40. Alternatively, the dimming structure 40 can include two structures with different refractive indices, by means of which a propagation direction of the light emitted from the dimming structure 40 can be adjusted to change the brightness at different viewing angles.

Embodiments of the present application do not limit the specific adjusting method of the dimming structure 40 on the light, as long as the light extracting efficiency of the first sub-pixel 10a is greater than the light extracting efficiency of the second sub-pixel 20a with the help of the dimming structure 40. The "light extracting efficiency of the first sub-pixel 10a" mentioned here refers to the brightness intensity of the light emitted by the first sub-pixel 10a and emitted from the display panel 100 within a unit viewing angle range. Similarly, the "light extracting efficiency of the second sub-pixel 20a" refers to the brightness intensity of the light emitted by the second sub-pixel 20a and emitted from the display panel 100 within a unit viewing angle range.

During use of the display panel 100, there is often a difference in the corresponding usage duration of the first sub-pixel 10a and the second sub-pixel 20a. Generally, the usage duration of the second sub-pixel 20a is longer than that of the first sub-pixel 10a. In view of this, in order to improve the overall service life of the display panel 100, in an embodiment of the present application, sizes of the first sub-pixel 10a and the second sub-pixel 20a are adjusted to make the orthographic projection area of the second sub-pixel 20a on the substrate 30 larger than the orthographic projection area of the first sub-pixel 10a on the substrate 30, so that the second sub-pixel 20a can have a longer usage duration than the first sub-pixel 10a, thereby improving the overall service life of the display panel 100.

However, in view of the size difference between the first sub-pixel 10a and the second sub-pixel 20a, the first sub-pixel 10a and the second sub-pixel 20a are prone to have a display difference when observed at a normal viewing angle, and thus may adversely affect the user's viewing experience at a normal viewing angle as the display panel 100 switches between different modes. Therefore, in an embodiment of the present application, there is further provided a dimming structure 40, which makes the light extracting efficiency of the first sub-pixel 10a greater than that of the second sub-pixel 20a. In this way, the difference in light extracting efficiency between the first sub-pixel 10a and the second sub-pixel 20a is used to reduce the display difference between the first sub-pixel 10a and the second sub-pixel 20a caused by the size difference between the first sub-pixel 10a and the second sub-pixel 20a, reduce the difference in display effects when the display panel 100 switches between different modes, and improve the user's corresponding viewing experience.

In summary, in an embodiment of the present application, by setting the orthographic projection area on the substrate 30 of the second sub-pixel 20a to be larger than that of the first sub-pixel 10a, the second sub-pixel 20a can have a longer usage duration than the first sub-pixel 10a, thereby improving the overall service life of the display panel 100. Furthermore, by providing the dimming structure 40, the light extracting efficiency of the first sub-pixel 10a is greater than the light extracting efficiency of the second sub-pixel 20a, thereby reducing the display difference between the first sub-pixel 10a and the second sub-pixel 20a when emitting light, reducing the display effect difference when the display panel 100 switches between different modes, improving the user's corresponding viewing experience, and achieving a simultaneous improvement in service life and display effect.

It should be noted that, in addition to the first sub-pixel 10a of the first color, the first type of pixels 10 may further include sub-pixels of other colors, and in addition to the second sub-pixel 20a of the first color, the second type of pixels 20 may further include sub-pixels of other colors. Embodiments of the present application do not limit the specific pixel types and specific pixel arrangements of the first type of pixels 10 and the second type of pixels 20. Optionally, the first type of pixels 10 further comprise a third sub-pixel 10b of a second color, and the second type of pixels 20 further comprise a fourth sub-pixel 20b of the second color, an orthographic projection area of the fourth sub-pixel 20b on the substrate 30 is larger than an orthographic projection area of the third sub-pixel 10b on the substrate 30, and the light extracting efficiency of the third sub-pixel 10b is greater than the light extracting efficiency of the fourth sub-pixel 20b.

In addition, embodiments of the present application do not limit the specific working mode of the display panel 100. Exemplarily, the display panel 100 comprises at least an anti-peeping display mode, and further comprises at least one of a wide-viewing angle display mode and a high-brightness display mode. Here, in the anti-peeping display mode, the first type of pixels 10 emit light, and the second type of pixels 20 do not emit light. In the wide-viewing angle display mode, the first type of pixels 10 do not emit light, and the second type of pixels 20 emit light. In the high-brightness display mode, both the first type of pixels 10 and the second type of pixels 20 emit light.

In some embodiments, as shown in Fig. 1 and Fig. 2, the display panel 100 comprises a pixel defining layer 50 located on one side of the substrate 30, and the pixel defining layer 50 comprises a pixel defining portion 51 and a first pixel opening 52 and a second pixel opening 53 enclosed by the pixel defining portion 51 and spaced apart. The first sub-pixel 10a comprises a first light-emitting portion 12 located in the first pixel opening 52, and the second sub-pixel 20a comprises a second light-emitting portion 22 located in the second pixel opening 53, and an orthographic projection area of the second pixel opening 53 on the substrate 30 is larger than an orthographic projection area of the first pixel opening 52 on the substrate 30.

The pixel defining layer 50 is a film structure used to define the positions of the sub-pixels in the display panel 100. The pixel defining layer 50 comprises a pixel defining portion 51 and a first pixel opening 52 and a second pixel opening 53 enclosed by the pixel defining portion 51. The first pixel opening 52 and the second pixel opening 53 are used to accommodate some structures of the respective sub-pixels. Exemplarily, the display panel 100 further comprises a device layer, which comprises an anode layer, a light-emitting layer, and a cathode layer that are stacked. The sub-pixels each comprise an anode in the anode layer, a light-emitting portion in the light-emitting layer, and a cathode in the cathode layer.

Embodiments of the present application do not limit a specific positional relationship of the pixel defining layer 50 and the device layer. For example, a portion of the structures in the anode layer can be exposed in the first pixel opening 52 and the second pixel opening 53, and the other structures can be covered by the pixel defining portion 51. Different light-emitting portions in the light-emitting layer are provided at the corresponding positions of the first pixel opening 52 and the second pixel opening 53. The cathode layer can be a whole-surface structure, and a portion of the structure is provided at the corresponding positions of the first pixel opening 52 and the second pixel opening 53, and the other portion of the structure is provided on a side of the pixel defining portion 51 facing away from the substrate 30.

It should be noted that a through hole is provided in the pixel defining layer 50, and an inner side wall of the through hole has an inclined structure. In other words, the through hole comprises an upper opening and a lower opening, a cross-section of the through hole along the thickness direction Y of the display panel 100 should be in the shape of an inverted trapezoid, that is, the upper opening size is larger than the lower opening size. The first pixel opening 52 and the second pixel opening 53 mentioned in embodiments of the present application are the lower openings of the pixel defining layer 50 at different through hole positions.

In an embodiment of the present application, the structure of the pixel defining layer 50 is adjusted, and the size of the second pixel opening 53 is set to be larger than the size of the first pixel opening 52, so that the orthographic projection area of the second light-emitting portion 22 formed at the second pixel opening 53 on the substrate 30 is larger than the orthographic projection area of the first light-emitting portion 12 formed at the first pixel opening 52 on the substrate 30, thereby increasing the usage duration of the second sub-pixel 20a relative to the first sub-pixel 10a, thereby increasing the overall service life of the display panel 100.

In some embodiments, as shown in Fig. 1 and Fig. 2, the dimming structure 40 comprises a filtering layer 41, which comprises a first filtering portion 411 and a second filtering portion 412. An orthographic projection of the first filtering portion 411 on the substrate 30 overlaps with the orthographic projection of the first sub-pixel 10a on the substrate 30, and an orthographic projection of the second filtering portion 412 on the substrate 30 overlaps with the orthographic projection of the second sub-pixel 20a on the substrate 30. A thickness of the first filtering portion 411 is less than a thickness of the second filtering portion 412.

The filtering layer 41 is a film structure for filtering a portion of the light in the display panel 100. Specifically, the filtering layer 41 may include a filtering portion, which can selectively absorb or limit light in a certain spectral range and allow the unabsorbed portion of the light to pass smoothly, thereby achieving the purpose of selective filtering.

The filtering layer 41 comprises a first filtering portion 411 corresponding to the first sub-pixel 10a, and a second filtering portion 412 corresponding to the second sub-pixel 20a. The first filtering portion 411 is to filter at least a portion of the light emitted from the first sub-pixel 10a, and the second filtering portion 412 is to filter at least a portion of the light emitted from the second sub-pixel 20a. Exemplarily, the first filtering portion 411 and the second filtering portion 412 are also both of the first color. For example, if the first sub-pixel 10a and the second sub-pixel 20a are both configured to emit red light, the first filtering portion 411 and the second filtering portion 412 can both be red filtering portions.

It should be noted that embodiments of the present application do not limit the specific positions of the first filtering portion 411 and the second filtering portion 412. Optionally, the orthographic projection of the first filtering portion 411 on the substrate 30 can cover the orthographic projection of the first light-emitting portion 12 on the substrate 30, and similarly, the orthographic projection of the second filtering portion 412 on the substrate 30 can cover the orthographic projection of the second light-emitting portion 22 on the substrate 30. Further optionally, the orthographic projection area of the second filtering portion 412 on the substrate 30 is larger than the orthographic projection area of the first filtering portion 411 on the substrate 30, so that the orthographic projection sizes corresponding to the first filtering portion 411 and the second filtering portion 412 can be adapted to the orthographic projection sizes corresponding to the first sub-pixel 10a and the second sub-pixel 20a.

In addition, embodiments of the present application do not limit the relative relationship of the first filtering portion 411 and the second filtering portion 412. Optionally, the first filtering portion 411 can be connected to the second filtering portion 412 as an integral whole, or the first filtering portion 411 can be spaced apart from the second filtering portion 412.

Furthermore, in the present application, a differentiated design is also made for the first filtering portion 411 and the second filtering portion 412, so that the thickness of the first filtering portion 411 is less than the thickness of the second filtering portion 412, which helps to make the light extracting efficiency of the first sub-pixel 10a greater than the light extracting efficiency of the second sub-pixel 20a. Specifically, the thickness of the filtering portion refers to the size of the filtering portion in the thickness direction Y, and the absorption and limiting effect of the filtering portion on light is often positively correlated with its thickness size, that is, the greater the thickness of the filtering portion, the stronger the filtering effect of the filtering portion on light.

On this basis, in an embodiment of the present application, the thickness of the first filtering portion 411 is set to be less than the thickness of the second filtering portion 412, so that the filtering effect of the first filtering portion 411 on the light emitted from the first sub-pixel 10a is smaller than the filtering effect of the second filtering portion 412 on the light emitted from the second sub-pixel 20a, thereby making the light extracting efficiency corresponding to the first sub-pixel 10a greater than the light extracting efficiency corresponding to the second sub-pixel 20a, reducing the difference in display effects of the display panel 100 in different modes.

In some embodiments, referring to Figs. 1 and 3, the first filtering portion 411 is connected to the second filtering portion 412, the filtering layer 41 comprises a first surface M1 facing away from the substrate 30, and a concave portion B formed by recessing inward from the first surface M1. An orthographic projection of the concave portion B on the substrate 30 overlaps with the orthographic projection of the first filtering portion 411 on the substrate 30.

Considering that the first filtering portion 411 and the second filtering portion 412 can be used to filter light of the same color, the first filtering portion 411 and the second filtering portion 412 can be set to have the same color and material, and the first filtering portion 411 and the second filtering portion 412 can be connected and integrated, which is helpful to reduce the difficulty of preparing the first filtering portion 411 and the second filtering portion 412.

Furthermore, in order to make the thickness of the first filtering portion 411 less than the thickness of the second filtering portion 412, a concave portion B is further formed on the first surface M1, here the first surface M1 is a surface of the filtering layer 41 facing away from the substrate 30. The concave portion B can be formed in a variety of ways, and illustratively, a flat first surface M1 can be formed on the light shielding layer 42 first, and then a position of the filtering layer 41 corresponding to the first sub-pixel 10a is etched to remove a portion of the structure of the filtering layer 41 corresponding to the position of the first sub-pixel 10a, so that the first surface M1 is concave to form a concave portion B at the position corresponding to the first sub-pixel 10a.

In summary, in an embodiment of the present application, considering that the first filtering portion 411 and the second filtering portion 412 can filter light of the same color, the first filtering portion 411 and the second filtering portion 412 are connected and provided as a whole, thereby reducing the difficulty of manufacturing the first filtering portion 411 and the second filtering portion 412. A concave portion B is further formed at a position corresponding to the first sub-pixel 10a, and the thickness of the first filtering portion 411 is less than the thickness of the second filtering portion 412 by means of the concave portion B, so that the light extracting efficiency corresponding to the first sub-pixel 10a is greater than the light extracting efficiency corresponding to the second sub-pixel 20a, thereby reducing the difference in display effects of the display panel 100 in different modes.

In some embodiments, as shown in Fig. 1 and Fig. 3, the dimming structure 40 further comprises a light shielding layer 42, which comprises a first light shielding opening 421 and a second light shielding opening 422 that are spaced apart, the first filtering portion 411 is provided in the first light shielding opening 421, and the second filtering portion 412 is at least partially provided in the second light shielding opening 422. The second filtering portion 412 is provided to partially extend beyond the surface of the light shielding layer 42 facing away from the substrate 30.

The light shielding layer 42 is a film structure capable of shielding light in the display panel 100, and a portion of the light propagating to the light shielding layer 42 can be absorbed by the light shielding layer 42, and thus cannot be emitted from the display panel 100. The light shielding layer 42 comprises a first light shielding opening 421 and a second light shielding opening 422 spaced apart. Similar to the first pixel opening 52 and the second pixel opening 53, the first light shielding opening 421 and the second light shielding opening 422 are also lower openings of the light shielding layer 42 at different positions.

The first light shielding opening 421 is provided corresponding to the first sub-pixel 10a, and the first filtering portion 411 is provided in the first light shielding opening 421. The second light shielding opening 422 is provided corresponding to the second sub-pixel 20a, and the second filtering portion 412 is provided in the second light shielding opening 422. The specific positional relationship between the first light shielding opening 421 and the second light shielding opening 422 relative to the first sub-pixel 10a and the second sub-pixel 20a is not limited in embodiments of the present application. Optionally, an orthographic projection of the first light shielding opening 421 on the substrate 30 covers an orthographic projection of the first light-emitting portion 12 on the substrate 30, and similarly, an orthographic projection of the second light shielding opening 422 on the substrate 30 covers an orthographic projection of the second light-emitting portion 22 on the substrate 30. Further optionally, the orthographic projection area of the second light shielding opening 422 on the substrate 30 is larger than the orthographic projection area of the first light shielding opening 421 on the substrate 30, so that the orthographic projection sizes corresponding to the first light shielding opening 421 and the second light shielding opening 422 can be adapted to the orthographic projection sizes corresponding to the first sub-pixel 10a and the second sub-pixel 20a.

Furthermore, in an embodiment of the present application, the second filtering portion 412 is provided to partially extend beyond the surface of the light shielding layer 42 facing away from the substrate 30, that is, the thickness of the second filtering portion 412 is greater than the thickness of the light shielding layer 42. This design helps to meet the requirements of the first filtering portion 411 and the second filtering portion 412 for thickness difference, so that the thickness of the second filtering portion 412 is greater than the thickness of the first filtering portion 411, thereby reducing the difference in display effects of the display panel 100 in different modes.

It should be noted that embodiments of the present application do not limit the relationship between the thickness of the first filtering portion 411 and the thickness of the light shielding layer 42. Optionally, the thickness of the first filtering portion 411 is not greater than the thickness of the light shielding layer 42, that is, the first filtering portion 411 does not extend beyond the surface of the light shielding layer 42 facing away from the substrate 30, which helps to reduce the filtering effect of the first filtering portion 411 on a portion of the light emitted from the first sub-pixel 10a, thereby improving the light extracting efficiency of the first sub-pixel 10a.

In some embodiments, as shown in Fig. 3, a distance L4 between the orthographic projection on the substrate 30 of the second light shielding opening 422 and that of the second sub-pixel 20a is greater than a distance L3 between the orthographic projection on the substrate 30 of the first light shielding opening 421 and that of the first sub-pixel 10a. The orthographic projection on the substrate 30 of the first sub-pixel 10a may correspond to the orthographic projection on the substrate 30 of the first pixel opening 52. On this basis, the distance L3 between the orthographic projection on the substrate 30 of the first light shielding opening 421 and that of the first sub-pixel 10a is the distance between the orthographic projection on the substrate 30 of the first light shielding opening 421 and that of the first pixel opening 52. Similarly, the distance L4 between the orthographic projection on the substrate 30 of the second light shielding opening 422 and that of the second sub-pixel 20a is the distance between the orthographic projection on the substrate 30 of the second light shielding opening 422 and that of the second pixel opening 53.

The distance between the orthographic projection on the substrate 30 of the sub-pixel and that of the corresponding light shielding opening is often related to the light-emitting viewing angle range corresponding to the sub-pixel. Specifically, the smaller the distance between the orthographic projection on the substrate 30 of the sub-pixel and that of the corresponding light shielding opening, the more obliquely emitted large viewing angle light emitted from the sub-pixel can be blocked by the light shielding layer 42. The larger the distance between the orthographic projection on the substrate 30 of the sub-pixel and that of the corresponding light shielding opening, the more obliquely emitted large viewing angle light emitted from the sub-pixel can pass through the light shielding opening and leave the display panel 100.

In view of this, in the embodiment of the present application, the distance L4 between the orthographic projection of the second light shielding opening 422 and the orthographic projection of the second sub-pixel 20a on the substrate 30 is set to be greater than the distance L3 between the orthographic projection of the first light shielding opening 421 and the orthographic projection of the first sub-pixel 10a on the substrate 30, so that more large viewing angle light emitted by the first sub-pixel 10a can be blocked by the light shielding layer 42, thereby meeting the anti-peeping display needs corresponding to the first sub-pixel 10a, and more large viewing angle light emitted by the second sub-pixel 20a can be emitted from the second light shielding opening 422 and leave the display panel 100, thereby meeting the wide-viewing angle display needs corresponding to the second sub-pixel 20a.

In some embodiments, the refractive index of the filtering layer 41 is greater than the refractive index of the light shielding layer 42.

Since there is a difference in refractive index between the filtering layer 41 and the light shielding layer 42, the propagation direction of the light entering from the filtering layer 41 into the light shielding layer 42 will change. Further referring to Fig. 3, at a peripheral side wall of the light shielding opening, the light shielding layer 42 will be connected with the filtering layer 41 to form a first interface J1. At the first interface J1, since the refractive index of the filtering layer 41 is greater than the refractive index of the light shielding layer 42, the refraction angle of the light on a side of the filtering layer 41 is smaller than the refraction angle on a side of the light shielding layer 42. On this basis, portion of the light propagating in the filtering layer 41 and travelling to the first interface J1 will be totally reflected at the first interface J1, thereby reducing the amount of light entering the light shielding layer 42 and improving the light extracting efficiency corresponding to the sub-pixel.

In an embodiment of the present application, by setting the refractive index of the filtering layer 41 to be greater than the refractive index of the light shielding layer 42, portion of the light reaching the first interface J1 will be totally reflected, thereby reducing the amount of light entering the light shielding layer 42. This helps to further increase the light extracting efficiency corresponding to the first sub-pixel 10a, reduce the display difference caused by the size difference between the first sub-pixel 10a and the second sub-pixel 20a, and improve the user's viewing experience.

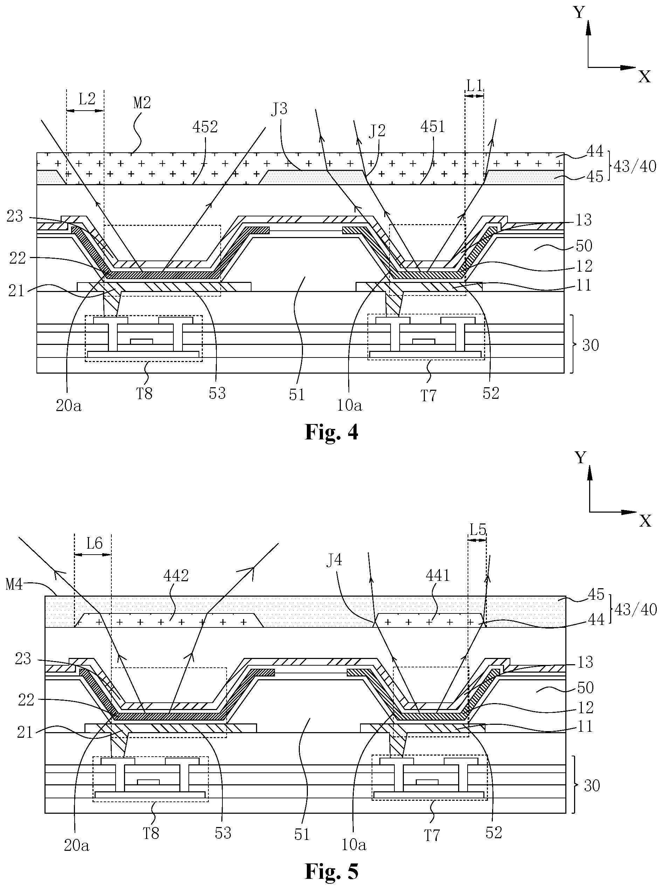

In some embodiments, referring to Fig. 1 and Fig. 4, the dimming structure 40 further comprises a light-adjusting layer 43 configured to change the propagation direction of the light emitted by the first sub-pixel 10a and the second sub-pixel 20a.

The light-adjusting layer 43 is provided at a side of the first sub-pixel 10a and the second sub-pixel 20a facing away from the substrate 30, that is, at the light-emitting side of the first sub-pixel 10a and the second sub-pixel 20a. The light-adjusting layer 43 is a film layer structure in the display panel 100 that can change the propagation direction of light, and can be in various forms. Specifically, the light-adjusting layer 43 may include at least two film layer structures with different refractive indices. At an interface of the two film layer structures, the light emitted by the first sub-pixel 10a or the second sub-pixel 20a will change the propagation direction due to the refraction principle. Alternatively, the light-adjusting layer 43 may include a reflective layer, and the light propagating to the reflective layer can be reflected by the reflective layer and change the propagation direction.

Furthermore, in an embodiment of the present application, structures of the light-adjusting layer 43 at the first sub-pixel 10a and the second sub-pixel 20a can be differentiated, so that the light-adjusting layer 43 can have different adjustment effects on the light emitted by the first sub-pixel 10a and the second sub-pixel 20a, thereby achieving an effect that the light extracting efficiency corresponding to the first sub-pixel 10a is greater than the light extracting efficiency corresponding to the second sub-pixel 20a, reducing the display difference caused by the size difference between the first sub-pixel 10a and the second sub-pixel 20a, and improving the user's viewing experience.

In some embodiments, the light-adjusting layer 43 comprises a low-refractive index layer 45 and a high-refractive index layer 44 that are stacked, a refractive index of the material of the high-refractive index layer 44 is greater than a refractive index of the material of the low-refractive index layer 45.

The high-refractive index layer 44 and the low-refractive index layer 45 are film structures having different materials. Due to the different material compositions, the refractive indexes of the materials corresponding to the high-refractive index layer 44 and the low-refractive index layer 45 are different. On this basis, the light propagating to the interface of the high-refractive index layer 44 and the low-refractive index layer 45 will be refracted or totally reflected, thereby changing the propagation direction of the light and improving the display effect of the display panel 100.

It should be noted that the high-refractive index layer 44 and the low-refractive index layer 45 can have a variety of positional relationships, for example, the high-refractive index layer 44 can be at least partially located on a side of the low-refractive index layer 45 facing away from the substrate 30, or the low-refractive index layer 45 can be at least partially located on a side of the high-refractive index layer 44 facing away from the substrate 30, as long as the low-refractive index layer 45 and the high-refractive index layer 44 can contact each other to form an interface, so as to improve the corresponding light extracting efficiency by changing the propagation direction of the light. Optionally, at the interface of the high-refractive index layer 44 and the low-refractive index layer 45, at least a portion of the large viewing angle light can change its propagation direction to a small viewing angle light due to refraction or total reflection, thereby helping to improve the light extracting efficiency.

In an embodiment of the present application, at least one of the high-refractive index layer 44 and the low-refractive index layer 45 can be set to have different shapes or sizes at different positions of the display panel 100, so that the light-adjusting layer 43 can have different adjustment effects on the first sub-pixel 10a and the second sub-pixel 20a. In this way, only a simple adjustment is required to make the light extracting efficiency of the first sub-pixel 10a greater than the light extracting efficiency of the second sub-pixel 20a, which has strong flexibility and practicality.

In some embodiments, as shown in Fig. 1 and Fig. 4, the low-refractive index layer 45 comprises a first low-refraction opening 451 corresponding to the first sub-pixel 10a, and a second low-refraction opening 452 corresponding to the second sub-pixel 20a, the high-refractive index layer 44 at least partially fills the first low-refraction opening 451 and the second low-refraction opening 452.

The low-refractive index layer 45 comprises a first low-refraction opening 451 and a second low-refraction opening 452. Similar to the first pixel opening 52 and the second pixel opening 53, the first low-refraction opening 451 and the second low-refraction opening 452 are lower openings of the low-refractive index layer 45 at different positions. The first low-refraction opening 451 is provided corresponding to the first sub-pixel 10a, and the second low-refraction opening 452 is provided corresponding to the second sub-pixel 20a. The specific positional relationship between the first low-refraction opening 451 and the second low-refraction opening 452 relative to the first sub-pixel 10a and the second sub-pixel 20a is not limited in embodiments of the present application. Optionally, an orthographic projection of the first low-refraction opening 451 on the substrate 30 can cover an orthographic projection of the first light-emitting portion 12 on the substrate 30, and similarly, an orthographic projection of the second low-refraction opening 452 on the substrate 30 can cover an orthographic projection of the second light-emitting portion 22 on the substrate 30.

The high-refractive index layer 44 at least partially fills the first low-refraction opening 451 and the second low-refraction opening 452. Here, the high-refractive index layer 44 may be located only in the low-refraction opening, that is, the high-refractive index layer 44 only comprises independent structures provided in different low-refraction openings and spaced from each other, or the high-refractive index layer 44 may be partially located in the first low-refraction opening 451 and the second low-refraction opening 452, and partially located on a side of the low-refractive index layer 45 facing toward or facing away from the substrate 30, so that the structures in the first low-refraction opening 451 and the second low-refraction opening 452 in the high-refractive index layer 44 can be connected as a whole.

Further, in an embodiment of the present application, the high-refractive index layer 44 and the low-refractive index layer 45 can be in contact with each other at side walls around the first low-refraction opening 451 and the second low-refraction opening 452, that is, the interface between the high-refractive index layer 44 and the low-refractive index layer 45 comprises corresponding side walls of the first low-refraction opening 451 and the second low-refraction opening 452. On this basis, in view of the difference in light extracting efficiency corresponding to the first sub-pixel 10a and the second sub-pixel 20a, the sizes of the first low-refraction opening 451 and the second low-refraction opening 452 can be adjusted to be different, or the inclination angles of the corresponding side walls of the first low-refraction opening 451 and the second low-refraction opening 452 can be adjusted to be different, so that the light-adjusting layer 43 has different adjustment effects on the first sub-pixel 10a and the second sub-pixel 20a, so that the light extracting efficiency corresponding to the first sub-pixel 10a can be greater than the light extracting efficiency corresponding to the second sub-pixel 20a.

In some embodiments, the distance L2 between the orthographic projection on the substrate 30 of the second low-refraction opening 452 and that of the second sub-pixel 20a is greater than the distance L1 between the orthographic projection on the substrate 30 of the first low-refraction opening 451 and that of the first sub-pixel 10a. The orthographic projection on the substrate 30 of the first sub-pixel 10a may correspond to the orthographic projection on the substrate 30 of the first pixel opening 52. On this basis, the distance L1 between the orthographic projection on the substrate 30 of the first low-refraction opening 451 and that of the first sub-pixel 10a is the distance between the orthographic projection on the substrate 30 of the first low-refraction opening 451 and that of the first pixel opening 52. Similarly, the distance L2 between the orthographic projection on the substrate 30 of the second low-refraction opening 452 and that of the second sub-pixel 20a is the distance between the orthographic projection on the substrate 30 of the second low-refraction opening 452 and that of the second pixel opening 53.

The orthographic projection of the first low-refraction opening 451 on the substrate 30 can cover or even exceed the orthographic projection of the first sub-pixel 10a on the substrate 30, and the larger the distance L1 between the orthographic projection of the first low-refraction opening 451 and the orthographic projection of the first sub-pixel 10a on the substrate 30, the more the first low-refraction opening 451 covers and extends beyond the first sub-pixel 10a. In combination with the above content, it can be seen that the peripheral side wall of the first low-refraction opening 451 is the second interface J2 between the low-refractive index layer 45 and the high-refractive index layer 44, and the light emitted by the first sub-pixel 10a can be refracted or totally reflected at the second interface J2, so that a portion of the large viewing angle light is converted into a small viewing angle light, thereby improving the light extracting efficiency.

On this basis, if the distance L1 between the orthographic projection of the first low-refraction opening 451 and the orthographic projection of the first sub-pixel 10a on the substrate 30 is larger, the light of a wider viewing angle range emitted from the first sub-pixel 10a can pass through the first low-refraction opening 451 to propagate to the second interface J2, thereby being converted into a small viewing angle light. In other words, the larger the distance L1 between the orthographic projection of the first low-refraction opening 451 and the orthographic projection of the first sub-pixel 10a on the substrate 30, the stronger the light efficiency gain of the light-adjusting layer 43 for the light emitted by the first sub-pixel 10a, and the higher the light extracting efficiency corresponding to the first sub-pixel 10a. The same applies to the second low-refraction opening 452, and details will not be repeated in embodiments of the present application.

In view of this, in an embodiment of the present application, the distance L2 between the orthographic projection of the second low-refraction opening 452 and the orthographic projection of the second sub-pixel 20a on the substrate 30 is set to be greater than the distance L1 between the orthographic projection of the first low-refraction opening 451 and the orthographic projection of the first sub-pixel 10a on the substrate 30, so that the light-adjusting layer 43 has a stronger light efficiency gain for the first sub-pixel 10a than for the second sub-pixel 20a, thereby achieving an effect that the corresponding light extracting efficiency of the first sub-pixel 10a is greater than the corresponding light extracting efficiency of the second sub-pixel 20a, thereby improving the user's viewing experience.

In some embodiments, the distance between the orthographic projections of the first low-refraction opening 451 and the first sub-pixel 10a on the substrate 30 is L1, and the distance between the orthographic projections of the second low-refraction opening 452 and the second sub-pixel 20a on the substrate 30 is L2, where L1 and L2 satisfy: 0≤L1≤1µm, 1µm≤L2.

In order to improve the light efficiency gain of the light-adjusting layer 43 to the first sub-pixel 10a, so that the first sub-pixel 10a has a higher light extracting efficiency, an embodiment of the present application restricts the size of the first low-refraction opening 451 so that the distance L1 is not greater than 1µm. Further, considering that the smaller the size of the first low-refraction opening 451, the less light enters the first low-refraction opening 451, which is also likely to affect the amount of light propagating to the second interface J2, affecting the light efficiency gain of the light-adjusting layer 43 to the first sub-pixel 10a. In view of this, an embodiment of the present application also sets the distance L1 to be not less than 0, that is, the first low-refraction opening 451 can completely cover the orthographic projection of the first sub-pixel 10a on the substrate 30, so that most of the light emitted by the first sub-pixel 10a can be transmitted to the second interface J2 through the first low-refraction opening 451, thereby improving the light efficiency gain of the light-adjusting layer 43 to the first sub-pixel 10a. Optionally, L1 may be one of 0, 0.1 µm, 0.3 µm, 0.5 µm, 0.8 µm and 1 µm.

In order to satisfy the difference in light extracting efficiency between the second sub-pixel 20a and the first sub-pixel 10a, it is necessary to make the distance L2 greater than the distance L1. Therefore, an embodiment of the present application sets L2 to be no less than 1 µm, thereby satisfying the size difference between the distance L1 and the distance L2, so that the light-adjusting layer 43 can have different light efficiency gains for the first sub-pixel 10a and the second sub-pixel 20a, thereby achieving that the light extracting efficiency corresponding to the first sub-pixel 10a is greater than the light extracting efficiency corresponding to the second sub-pixel 20a.

It should be noted that the maximum size corresponding to the distance L2 needs to be determined based on the distance between the first low-refraction opening 451 and the second low-refraction opening 452. In other words, it needs to be determined based on the distance between the first sub-pixel 10a and the adjacent second sub-pixel 20a, and in the display panels 100 with different resolutions, the distance between the first sub-pixel 10a and the second sub-pixel 20a can be set to be different, so it needs to be determined based on the actual product. Embodiments of the present application do not limit the maximum size corresponding to the distance L2. Optionally, L2 can be one of 1 µm, 1.5 µm, 2 µm, 3 µm and 5 µm.

In some embodiments, as shown in Fig. 4, the high-refractive index layer 44 partially extends beyond the surface of the low-refractive index layer 45 facing away from the substrate 30, and the high-refractive index layer 44 comprises a second surface M2 facing away from the substrate 30, and the second surface M2 is a flat surface.

In addition to the portion inside the first low-refraction opening 451 and the second low-refraction opening 452, the high-refractive index layer 44 further includes a partial structure that extends beyond the surface of the low-refractive index layer 45 facing away from the substrate 30. Here, the partial structure of the high-refractive index layer 44 that extends beyond the surface of the low-refractive index layer 45 facing away from the substrate 30 can be connected to the partial structure inside the first low-refraction opening 451 and the second low-refraction opening 452, so as to improve the stability of the overall structure of the high-refractive index layer 44.

Further, the high-refractive index layer 44 comprises a second surface M2 facing away from the substrate 30, and the second surface M2 is located at the side of the low-refractive index layer 45 facing away from the substrate 30 and is spaced apart from the surface of the low-refractive index layer 45 facing away from the substrate 30 in the thickness direction Y. Here, the second surface M2 is a flat surface, that is, the second surface M2 is relatively flat. On this basis, when preparing other film layer structures on the side of the light-adjusting layer 43 facing away from the substrate 30, the second surface M2 can provide a good surface condition for the preparation of other film layer structures, thereby improving the bonding effect of other film layer structures and the high-refractive index layer 44, and improving the reliability of the display panel 100 and the preparation yield rate.

It should be noted that the flat surface mentioned in the embodiment of the present application does not require that the second surface M2 is completely parallel to a plane where the substrate 30 is located. Considering the influence of factors such as preparation accuracy, the second surface M2 may have certain unevenness. Embodiments of the present application do not limit this, as long as the second surface M2 can be relatively flat.

In addition, in an embodiment of the present application, since the high-refractive index layer 44 partially extend beyond the surface of the low-refractive index layer 45 facing away from the substrate 30, the surface of the low-refractive index layer 45 facing away from the substrate 30 is the third interface J3 between the low-refractive index layer 45 and the high-refractive index layer 44. On this basis, a portion of the light that enters the low-refractive index layer 45 and propagates to the third interface J3 will be refracted at the third interface J3, and a portion of the large viewing angle light is converted into a small viewing angle light, which helps to further improve the light efficiency gain of the light-adjusting layer 43 for the first sub-pixel 10a.

In some embodiments, referring to Fig. 1 and Fig. 5, the high-refractive index layer 44 comprises a first high-refraction portion 441 and a second high-refraction portion 442 spaced apart, the orthographic projection of the first high-refraction portion 441 on the substrate 30 overlaps with the orthographic projection of the first sub-pixel 10a on the substrate 30, the orthographic projection of the second high-refraction portion 442 on the substrate 30 overlaps with the orthographic projection of the second sub-pixel 20a on the substrate 30, and the low-refractive index layer 45 covers outer surfaces of the first high-refraction portion 441 and the second high-refraction portion 442.

The first high-refraction portion 441 and the second high-refraction portion 442 are different structures of the high-refractive index layer 44 at different positions and are independent of each other. The first high-refraction portion 441 is provided corresponding to the first sub-pixel 10a, and the second high-refraction portion 442 is provided corresponding to the second sub-pixel 20a. Optionally, the orthographic projection of the first high-refraction portion 441 on the substrate 30 covers the orthographic projection of the first pixel opening 52 on the substrate 30, and similarly, the orthographic projection of the second high-refraction portion 442 on the substrate 30 covers the orthographic projection of the second pixel opening 53 on the substrate 30.

The low-refractive index layer 45 covers the outer surfaces of the first high-refraction portion 441 and the second high-refraction portion 442, that is, the low-refractive index layer 45 can contact the outer surfaces of the first high-refraction portion 441 and the second high-refraction portion 442 to form an interface, wherein the low-refractive index layer 45 can have a variety of structural forms. Specifically, the low-refractive index layer 45 can be completely located between adjacent high-refraction portions, that is, the low-refractive index layer 45 will not extend beyond the surface of the high-refractive index layer 44 facing away from the substrate 30, or the low-refractive index layer 45 can also be partially located between adjacent high-refraction portions, and partially located on the side of the high-refractive index layer 44 facing toward or facing away from the substrate 30, and the embodiments of the present application do not limit this.

Further, in an embodiment of the present application, the high-refractive index layer 44 and the low-refractive index layer 45 can contact the outer surfaces of the first high-refraction portion 441 and the second high-refraction portion 442 to form an interface, so that the light propagating to the outer surfaces of the first high-refraction portion 441 and the second high-refraction portion 442 can be refracted or totally reflected, so as to achieve the light adjustment effect of the light-adjusting layer 43 on the light emitted by the first sub-pixel 10a and the second sub-pixel 20a. On this basis, the size and shape of the first high-refraction portion 441 and the second high-refraction portion 442 can be set differently, so that the light-adjusting layer 43 has different adjustment effects on the first sub-pixel 10a and the second sub-pixel 20a, so that the light extracting efficiency corresponding to the first sub-pixel 10a can be greater than the light extracting efficiency corresponding to the second sub-pixel 20a, which has strong flexibility and practicality.

In some embodiments, a distance L6 between the orthographic projection of the outer contour of the second high-refraction portion 442 and the orthographic projection of the outer contour of the second sub-pixel 20a on the substrate 30 is greater than a distance L5 between the orthographic projection of the outer contour of the first high-refraction portion 441 and the orthographic projection of the outer contour of the first sub-pixel 10a on the substrate 30.

The orthographic projection of the first high-refraction portion 441 on the substrate 30 can cover or even exceed the orthographic projection of the first sub-pixel 10a on the substrate 30, and the larger the distance L5 between the orthographic projection of the outer contour of the first high-refraction portion 441 and the orthographic projection of the outer contour of the first sub-pixel 10a on the substrate 30, the more the first high-refraction portion 441 covers and extends beyond the first sub-pixel 10a. In combination with the above content, it can be known that at least a portion of the low-refractive index layer 45 fills between the first high-refraction portion 441 and the second high-refraction portion 442, so the peripheral side wall of the first high-refraction portion 441 is the fourth interface J4 between the low-refractive index layer 45 and the high-refractive index layer 44, and the light emitted by the first sub-pixel 10a can be refracted or totally reflected at the fourth interface J4, so that a portion of the large viewing angle light is converted into a small viewing angle light, thereby improving the light extracting efficiency.

On this basis, if the distance L5 between the orthographic projection of the outer contour of the first high-refraction portion 441 and the outer contour of the first sub-pixel 10a on the substrate 30 is larger, the light of a wider viewing angle range emitted from the first sub-pixel 10a can enter the first high-refraction portion 441 and propagate to the fourth interface J4, thereby converting into a small viewing angle light. In other words, the larger the distance L5 between the orthographic projections of the outer contour of the first high-refraction portion 441 and the outer contour of the first sub-pixel 10a on the substrate 30, the stronger the light efficiency gain of the light-adjusting layer 43 for the light emitted by the first sub-pixel 10a, and the higher the light extracting efficiency corresponding to the first sub-pixel 10a. The second high-refraction portion 442 is similar, and embodiments of the present application will not be repeated.

In view of this, in an embodiment of the present application, the distance L6 between the orthographic projection of the outer contour of the second high-refraction portion 442 and the orthographic projection of the outer contour of the second sub-pixel 20a on the substrate 30 is set to be greater than the distance L5 between the orthographic projection of the outer contour of the first high-refraction portion 441 and the orthographic projection of the outer contour of the first sub-pixel 10a on the substrate 30, so that the light-adjusting layer 43 has a stronger light efficiency gain for the first sub-pixel 10a than for the second sub-pixel 20a, thereby achieving an effect that the corresponding light extracting efficiency of the first sub-pixel 10a is greater than the corresponding light extracting efficiency of the second sub-pixel 20a, thereby improving the user's viewing experience.

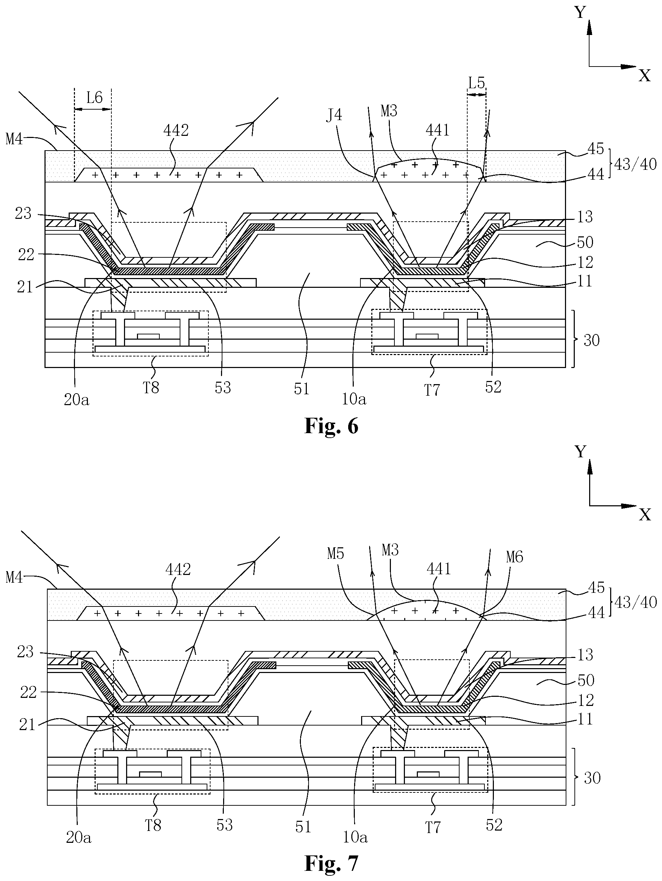

In some embodiments, referring to Fig. 1 and Fig. 6, the first high-refraction portion 441 comprises a third surface M3 facing away from the substrate 30, and the third surface M3 comprises an arc-shaped structure and protrudes in a direction away from the substrate 30.

The first high-refraction portion 441 has two opposite surfaces in the thickness direction Y, and the third surface M3 is a surface of the two surfaces that is relatively far away from the substrate 30. Further, by providing the third surface M3 with an arc-shaped structure and protruding in a direction away from the substrate 30, the first high-refraction portion 441 can be a convex lens-like structure, so that the first high-refraction portion 441 can achieve a gathering effect on the light emitted from the first sub-pixel 10a, thereby improving the light extracting efficiency corresponding to the first sub-pixel 10a.

In the related art, the overall size of the high-refraction portion is usually positively correlated with the size of the corresponding sub-pixel, and the size of the arc-shaped structure on the third surface M3 is usually positively correlated with the overall size of the high-refraction portion. On this basis, if the sub-pixel size is large, it is easy to cause the size of the arc-shaped structure on the third surface M3 on the corresponding high-refraction portion to be large, and due to the limitation of the film layer space where the high-refraction portion is located, it may not be able to meet the space requirements for the formation of the arc-shaped structure.

However, in an embodiment of the present application, since the first sub-pixel 10a itself is relatively small in size, the size of the first high-refraction portion 441 corresponding to the first sub-pixel 10a is also relatively small, and on this basis, the arc-shaped structure of the third surface M3 on the first high-refraction portion 441 can be formed without too much film layer space. In other words, since the first sub-pixel 10a itself is relatively small in size, the size of the arc-shaped structure on the third surface M3 corresponding thereto is also relatively small, and will not have an adverse effect on the overall size of the display panel 100.

In summary, in an embodiment of the present application, the third surface M3 can be provided to include an arc-shaped structure without affecting the overall size of the display panel 100. With the help of the arc-shaped structure, the gathering effect of the light emitted by the first sub-pixel 10a is improved, and the light extracting efficiency of the first sub-pixel 10a is improved, which is highly practical.

It should be noted that embodiments of the present application do not limit the specific shape of the second high-refraction portion 442. Optionally, the cross-section of the second high-refraction portion 442 may be in a regular trapezoidal shape, that is, a surface of the second high-refraction portion 442 facing away from the substrate 30 may be a flat surface.

In some embodiments, referring to Figs. 1 and 7, the first high-refraction portion 441 comprises a first side surface M5 and a second side surface M6 that are opposite to each other in a first direction X, the first side surface M5 comprises an arc-shaped structure and protrudes in a direction away from the second side surface M6, the first direction X is parallel to the plane where the substrate 30 is located, and the low-refractive index layer 45 is provided in contact with the first side surface M5.

The first side surface M5 and the second side surface M6 are two opposite side surfaces of the first high-refraction portion 441 in the first direction X, and the low-refractive index layer 45 is provided in contact with the first side surface M5, that is, the first side surface M5 may be the interface between the high-refractive index layer 44 and the low-refractive index layer 45. On this basis, in an embodiment of the present application, the first side surface M5 is provided to include an arc-shaped structure and protrude in a direction away from the second side surface M6, so as to achieve a gathering effect on the light emitted from the first sub-pixel 10a by means of the first side surface M5, thereby improving the light extracting efficiency corresponding to the first sub-pixel 10a.

Similarly, in some other embodiments, the second side surface M6 comprises an arc-shaped structure and protrudes in a direction away from the first side surface M5, and the low-refractive index layer 45 is provided in contact with the second side surface M6. In this way, the second side surface M6 can also be used to achieve a gathering effect on the light emitted from the first sub-pixel 10a, thereby improving the light extracting efficiency corresponding to the first sub-pixel 10a.

Embodiments of the present application do not limit the relationship between the first side surface M5 and the third surface M3. Optionally, as shown in Fig. 7, the third surface M3 and the first side surface M5 both include arc-shaped structures, which are connected to each other to form a continuous arc-shaped structure.

In some embodiments, as shown in Figs. 5 to 7, the low-refractive index layer 45 partially extends beyond the surfaces of the first high-refraction portion 441 and the second high-refraction portion 442 facing away from the substrate 30, and the low-refractive index layer 45 comprises a fourth surface M4 facing away from the substrate 30, and the fourth surface M4 is a flat surface.

In addition to the portion located between adjacent high-refraction portions, the low-refractive index layer 45 also has a partial structure that extends beyond the surface of the high-refractive index layer 44 facing away from the substrate 30. The partial structure of the low-refractive index layer 45 that extends beyond the surface of the high-refractive index layer 44 that is facing away from the substrate 30 can be connected to the partial structure between adjacent high-refraction portions, thereby improving the stability of the overall structure of the low-refractive index layer 45.

Further, the low-refractive index layer 45 comprises a fourth surface M4 facing away from the substrate 30, and the fourth surface M4 is located at the side of the high-refractive index layer 44 facing away from the substrate 30 and is spaced apart from the surface of the high-refractive index layer 44 facing away from the substrate 30 in the thickness direction Y. Here, the fourth surface M4 is a flat surface, that is, the fourth surface M4 is relatively flat. On this basis, when preparing other film layer structures on the side of the light-adjusting layer 43 facing away from the substrate 30, the fourth surface M4 can provide a good surface condition for the preparation of other film layer structures, thereby improving the bonding effect of other film layer structures and the low-refractive index layer 45, and improving the reliability of the display panel 100 and the preparation yield rate.

It should be noted that the flat surface mentioned in embodiments of the present application does not require that the fourth surface M4 is completely parallel to the plane where the substrate 30 is located. Considering the influence of factors such as preparation accuracy, the fourth surface M4 may have certain unevenness. Embodiments of the present application do not limit this, as long as the fourth surface M4 can be relatively flat.

In addition, in an embodiment of the present application, since the low-refractive index layer 45 partially extends beyond the surface of the high-refractive index layer 44 facing away from the substrate 30, the low-refractive index layer 45 can cover the surfaces of the first high-refraction portion 441 and the second high-refraction portion 442 facing away from the substrate 30, so that the surface of the first high-refraction portion 441 facing away from the substrate 30 can become the interface between the low-refractive index layer 45 and the high-refractive index layer 44, and with the help of this interface, it is helpful to further improve the light efficiency gain of the light-adjusting layer 43 for the first sub-pixel 10a.

In some embodiments, the material of the high-refractive index layer 44 comprises at least one of zirconium oxide, hafnium oxide, tantalum oxide, niobium oxide, titanium oxide, yttrium oxide, silicon nitride, strontium titanate, tungsten oxide and chromium oxide; and/or, the material of the low-refractive index layer 45 comprises at least one of quartz, fused quartz, fluorine-doped fused quartz, magnesium fluoride, calcium fluoride, aluminum fluoride and ytterbium fluoride.

In an embodiment of the present application, by restricting the material composition of the high-refractive index layer 44 and the low-refractive index layer 45, the refractive index of the material corresponding to the high-refractive index layer 44 can be higher than the refractive index of the material corresponding to the low-refractive index layer 45, so that the propagation direction of the light can be changed at the interface between the high-refractive index layer 44 and the low-refractive index layer 45, so as to adjust the light extraction effect corresponding to the first sub-pixel 10a and the second sub-pixel 20a, so that the light extracting efficiency corresponding to the first sub-pixel 10a can be greater than the light extracting efficiency corresponding to the second sub-pixel 20a, thereby reducing the display difference caused by the size difference between the first sub-pixel 10a and the second sub-pixel 20a, and improving the user's viewing experience.

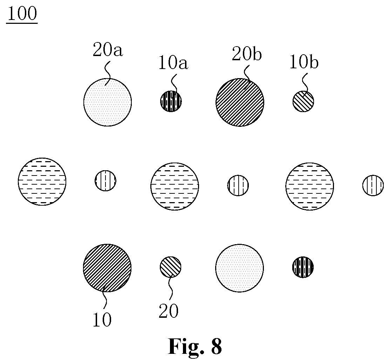

In some embodiments, as shown in Fig. 1, the first sub-pixel 10a is provided to surround the second sub-pixel 20a; or, referring to Fig. 8, the first sub-pixel 10a and the second sub-pixel 20a are provided side by side.

In an embodiment of the present application, the first sub-pixel 10a and the second sub-pixel 20a can have a variety of layouts. As shown in Fig. 1, the first sub-pixel 10a is provided to surround the second sub-pixel 20a, that is, the orthographic projection of the first sub-pixel 10a on the substrate 30 can be a ring-shaped structure, and the orthographic projection of the second sub-pixel 20a on the substrate 30 is located inside the ring-shaped structure. Optionally, the shape of the first sub-pixel 10a matches the shape of the second sub-pixel 20a, that is, if the orthographic projection of the first sub-pixel 10a on the substrate 30 is a square ring-shaped structure, the orthographic projection of the second sub-pixel 20a on the substrate 30 is a square-shaped structure. If the orthographic projection of the first sub-pixel 10a on the substrate 30 is a circular ring-shaped structure, the orthographic projection of the second sub-pixel 20a on the substrate 30 is a circular structure.

Alternatively, as shown in Fig. 8, the first sub-pixel 10a may be provided side by side with the second sub-pixel 20a, wherein other sub-pixels may exist between the first sub-pixel 10a and the second sub-pixel 20a that are closest to each other, or no other sub-pixel exists between the first sub-pixel 10a and the second sub-pixel 20a that are closest to each other, and embodiments of the present application do not limit this. In this case, the first sub-pixel 10a and the second sub-pixel 20a may be the same or different in shape. For example, if the orthographic projection of the first sub-pixel 10a on the substrate 30 is in a circular shape, the orthographic projection of the second sub-pixel 20a on the substrate 30 may be in a circular, square, or other shape.

It should be noted that the first type of pixels 10 comprises other sub-pixels in addition to the first sub-pixel 10a, and the second type of pixels 20 comprises other sub-pixels in addition to the second sub-pixel 20a. Embodiments of the present application do not limit the relative positional relationship between the other sub-pixels in the first type of pixels 10 and the other sub-pixels in the second type of pixels 20. Optionally, the first type of pixels 10 further comprises a third sub-pixel 10b of a second color, and the second type of pixels 20 further comprises a fourth sub-pixel 20b of the second color, and the positional relationship between the third sub-pixel 10b and the fourth sub-pixel 20b is similar to the positional relationship between the first sub-pixel 10a and the second sub-pixel 20a.

In an embodiment of the present application, the first sub-pixel 10a and the second sub-pixel 20a can be in a variety of arrangements, that is, the solutions provided in embodiments of the present application can be applied to a variety of different pixel arrangements, as long as the orthographic projection area of the first sub-pixel 10a on the substrate 30 is smaller than the orthographic projection area of the second sub-pixel 20a on the substrate 30. Such designs can improve applicability and meet the needs of different types of display panels 100.

In some embodiments, the first type of pixels 10 comprises a first electrode 11, a first light-emitting portion 12, and a second electrode 13 that are sequentially stacked in a direction away from the substrate 30, and the second type of pixels 20 comprises a third electrode 21, a second light-emitting portion 22, and a fourth electrode 23 that are sequentially stacked in a direction away from the substrate 30. The first electrode 11 is spaced apart from the third electrode 21; and/or the second electrode 13 is spaced apart from the fourth electrode 23. Figs. 2 to 7 show the situation where the first electrode 11 is spaced apart from the third electrode 21.

The first electrode 11 and the second electrode 13 are respectively the anode and cathode corresponding to the first type of pixels 10, the first light-emitting portion 12 is a main component of the first type of pixels 10 for realizing the light-emitting function, and the first electrode 11 and the second electrode 13 jointly drive and control whether the first light-emitting portion 12 emits light or not to meet the display needs of the first type of pixels 10. Similarly, the third electrode 21 and the fourth electrode 23 are respectively the anode and cathode corresponding to the second type of pixels 20, the second light-emitting portion 22 is a main component of the second type of pixels 20 for realizing the light-emitting function, and the third electrode 21 and the fourth electrode 23 jointly drive and control whether the second light-emitting portion 22 emits light or not to meet the display needs of the second type of pixels 20.

In combination with the foregoing, it can be seen that the first type of pixels 10 can be anti-peeping sub-pixels, and the second type of pixels 20 are normal sub-pixels, that is, non-anti-peeping sub-pixels. In different working modes, the first type of pixels 10 and the second type of pixels 20 may not emit light at the same time. Specifically, the display panel 100 comprises at least an anti-peeping display mode. In the anti-peeping display mode, the first type of pixels 10 emit light while the second type of pixels 20 do not emit light. On this basis, considering that in at least some working modes, the light-emitting moments corresponding to the first type of pixels 10 and the second type of pixels 20 do not completely match, the first light-emitting portion 12 of the first type of pixels 10 and the second light-emitting portion 22 of the second type of pixels 20 need to be independently controlled and driven to emit light.

In view of this, in an embodiment of the present application, the first electrode 11 and the third electrode 21 may be spaced apart to achieve an insulated arrangement of the first electrode 11 and the third electrode 21, thereby achieving independent control of the first light-emitting portion 12 and the second light-emitting portion 22 with the help of the mutually insulated first electrode 11 and the third electrode 21; or the second electrode 13 and the fourth electrode 23 may be spaced apart to achieve an insulated arrangement of the second electrode 13 and the fourth electrode 23, thereby achieving independent control of the first light-emitting portion 12 and the second light-emitting portion 22 with the help of the mutually insulated second electrode 13 and the fourth electrode 23.

It should be noted that, according to the needs of different display panels 100, the first electrode 11 and the third electrode 21 can be spaced apart, and the second electrode 13 and the fourth electrode 23 can be connected and provided as a whole. Alternatively, the first electrode 11 and the third electrode 21 can be connected and provided as a whole; and the second electrode 13 and the fourth electrode 23 can be spaced apart. Alternatively, the first electrode 11 and the third electrode 21 can be spaced apart; and the second electrode 13 and the fourth electrode 23 can be spaced apart, as long as at least one of the anode and the cathode in the first type of pixels 10 and the second type of pixels 20 is insulated from each other.

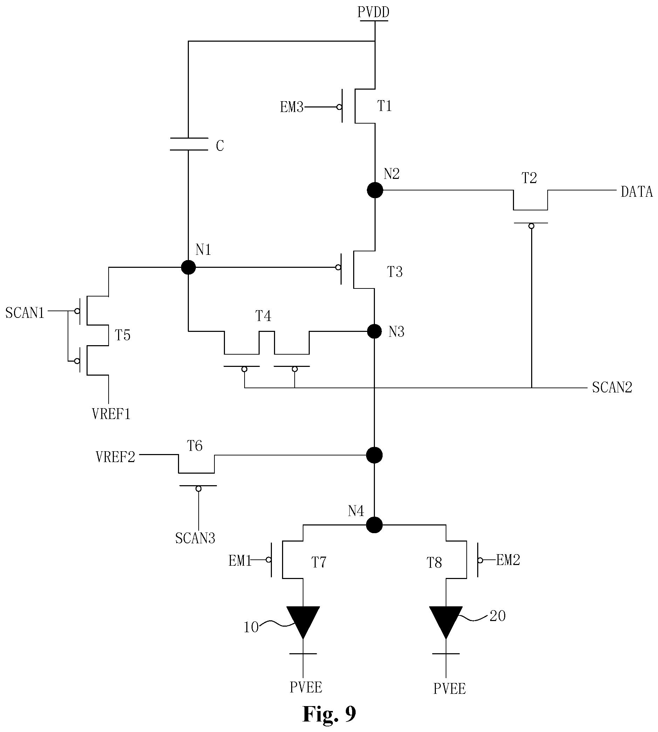

Embodiments of the present application do not limit the structure and relative relationship of the pixel circuits corresponding to the first type of pixels 10 and the second type of pixels 20. In some optional embodiments, the first electrode 11 and the third electrode 21 are spaced apart, and the second electrode 13 and the fourth electrode 23 are connected and provided as a whole. Further, referring to Figs. 2 and 9, some structures in the pixel circuits corresponding to the first type of pixels 10 and the second type of pixels 20 can be shared with each other, and the cathodes corresponding to the two can be electrically connected to the same second power supply signal PVEE. Eight transistors and one storage capacitor C are shown, each transistor comprises a first terminal, a second terminal and a control terminal for controlling conduction between the first terminal and the second terminal. Here, the first terminal of the seventh transistor T7 is connected to the first electrode 11 of the first type of pixels 10, and the control terminal is electrically connected to the first light-emitting signal EM1; the first terminal of the eighth transistor T8 is connected to the third electrode 21 of the second type of pixels 20, and the control terminal is electrically connected to the second light-emitting signal EM2.

On this basis, in addition to the seventh transistor T7 and the eighth transistor T8, the other transistors and the storage capacitor C of the pixel circuit corresponding to the first type of pixels 10 and the second type of pixels 20 are shared with each other. Here, the connection relationship and the connected signals of the storage capacitor C and most of the other transistors are consistent with those in the pixel circuit in the related art and will not be repeated in embodiments of the present application.

It should be noted that the first terminal of the first transistor T1 is electrically connected to the first power supply signal PVDD, and the control terminal is connected to the third light-emitting signal EM3. Different from the related art, the third light-emitting signal EM3 is transmitted and provided independently of the first light-emitting signal EM1 and the second light-emitting signal EM2.

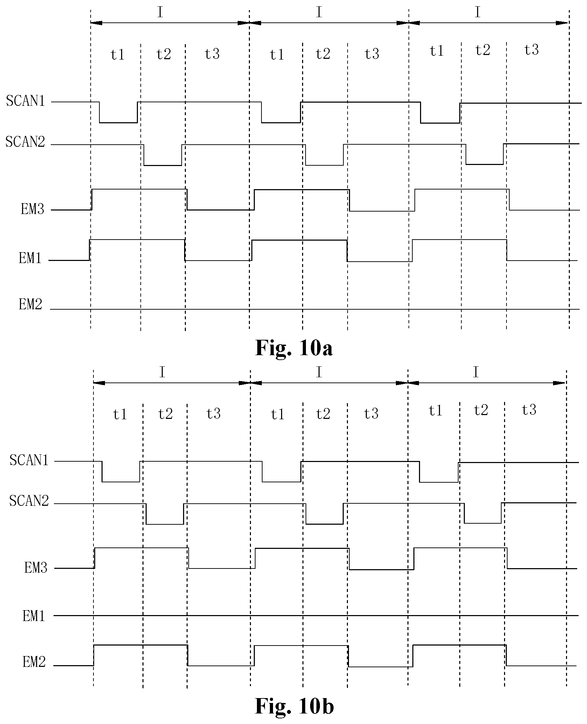

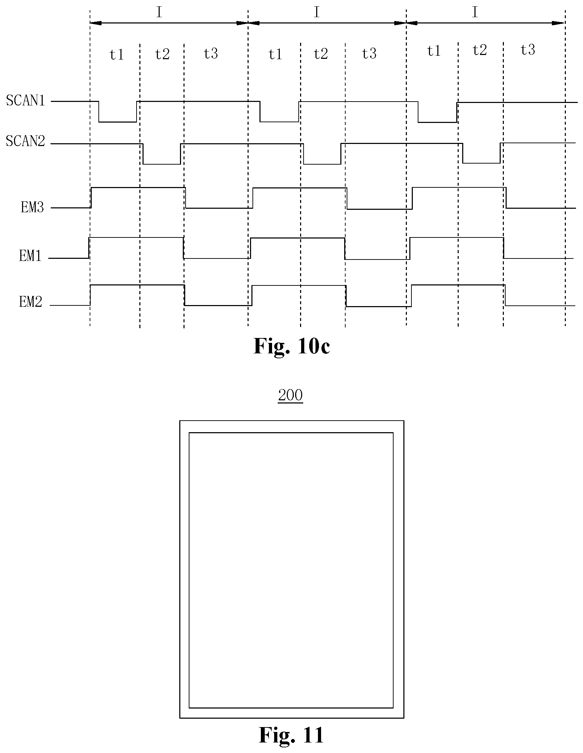

Further, Figs. 10a to 10c show a timing diagrams of the circuit structure corresponding to Fig. 9 at different stages. Specifically, the working process of the circuit structure comprises a first reset stage, a charging stage, a second reset stage and a light-emitting stage.

The first reset stage corresponds to a period t1, during which the fifth transistor T5 is in a turned-on state, and a voltage corresponding to the first reset signal VREF1 is charged into the N1 node.

The charging stage corresponds to a period t2, during which the second transistor T2 and the fourth transistor T4 are in a turned-on state, a voltage corresponding to the data signal DATA is charged into the storage capacitor C, the first terminal of the third transistor T3 is electrically connected to the control terminal to form a diode, and the voltage charged into the storage capacitor C is V_{DATA}-|V_{TH}|. Here, V_{DATA} represents the voltage value corresponding to the data signal DATA, and V_{TH} represents the corresponding threshold voltage.

The second reset stage corresponds to a period t3, during which the sixth transistor T6 is in a turned-on state, and a voltage corresponding to the second reset signal VREF2 is charged into the N4 node.

The light-emitting stage corresponds to a period t4, during which the first transistor T1 is in a turned-on state, and the storage capacitor C maintains the voltage charged in the charging stage on the control terminal of the third transistor T3. At least one of the seventh transistor T7 and the eighth transistor T8 is turned on to realize light-emitting display. Specifically, as shown in Figs. 1, 2 and 10a, if the first light-emitting signal EM1 controls the seventh transistor T7 to be turned on, and the second light-emitting signal EM2 does not control the eighth transistor T8 to be turned on, the first type of pixels 10 emit light and the second type of pixels 20 do not emit light, and the display panel 100 is in the anti-peeping display mode. As shown in Figs. 1, 2 and 10b, if the first light-emitting signal EM1 does not control the seventh transistor T7 to be turned on and the second light-emitting signal EM2 controls the eighth transistor T8 to be turned on, the first type of pixels 10 do not emit light and the second type of pixels 20 emit light, and the display panel 100 is in the wide-viewing angle display mode. As shown in Fig. 1, Fig. 2 and Fig. 10c, if the first light-emitting signal EM1 controls the seventh transistor T7 to be turned on and the second light-emitting signal EM2 controls the eighth transistor T8 to be turned on, the first type of pixels 10 emit light and the second type of pixels 20 also emit light, the display panel 100 is in a high-brightness display mode. The situation when the display panel 100 is in the anti-peeping display mode is shown in the figure.

It should be noted that in Fig. 9 and Figs.10a to 10c, the case where the transistors are PMOS transistors (turned on at low level, turned off at high level) is taken as an example for explanation. In the actual display panel 100, some or all of the transistors can be adjusted to NMOS transistors (turned on at high level, turned off at low level), and the corresponding timing can be adjusted accordingly, which will not be repeated here.

In some embodiments, the display panel 100 has at least a first working mode and a second working mode. In the first working mode, the first type of pixels 10 emit light and the second type of pixels 20 do not emit light. In the second working mode, both the first type of pixels 10 and the second type of pixels 20 emit light.

Additionally or alternatively, the display panel 100 has at least the first working mode and a third working mode. In the third working mode, the first type of pixels 10 do not emit light, and the second type of pixels 20 emit light.

In combination with the above content, it can be known that the first working mode is the anti-peeping display mode, the second working mode is the high-brightness display mode, and the third working mode is the wide-viewing angle display mode. In an embodiment of the present application, the display panel 100 has at least an anti-peeping display mode to meet the anti-peeping display needs. On this basis, the display panel 100 can further selectively include at least one of a wide-viewing angle display mode and a high-brightness display mode to meet the needs of large viewing angle display in different situations, with strong flexibility and practicality.

In a second aspect, referring to Fig. 11, an embodiment of the present application provides a display device 200, comprising the display panel according to any one of the aforementioned embodiments.

It should be noted that the display device 200 provided in embodiments of the present application has the beneficial effects of the display panel in any one of the aforementioned embodiments. The aforementioned description of the beneficial effects of the display panel can be referred to for details, and the detailed description will be omitted here.

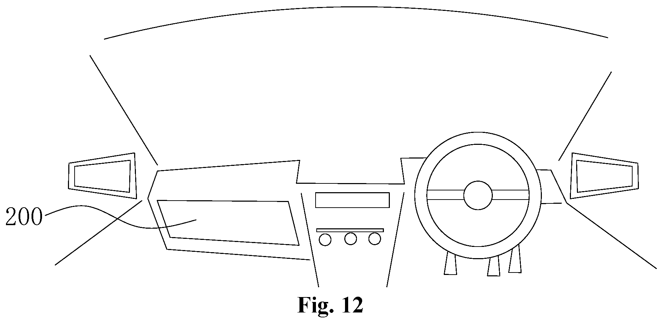

In a third aspect, embodiments of the present application provide a vehicle, referring to Fig. 12. The display device 200 provided in embodiments of the present application can be applied to the field of vehicle-mounted display in the vehicle, wherein the display device 200 is provided at the front passenger position. During the driving process of the vehicle, the display device 200 can control only the first type of pixels to emit light, while the second type of pixels do not emit light, so as to reduce the impact of the displayed image on the driver and improve driving safety. When the vehicle stops, the display device 200 can control the second type of pixels to emit light, so that the person in the driver's seat can also observe the displayed image, meeting the display needs.

Although embodiments disclosed in this application are as above, the content described is merely an embodiment adopted for facilitating the understanding of this application and is not intended to limit the present application. Those skilled in the art to which this application belongs can make any modifications and changes in the form and details of implementation without departing from the gist and scope disclosed in this application, but the scope of protection of this application shall still be subject to the scope defined in the attached claims.

## Claims

1. A display panel, comprising a first type of pixels and a second type of pixels, a light-emitting viewing angle range of the second type of pixels being greater than a light-emitting viewing angle range of the first type of pixels, the first type of pixels comprising a first sub-pixel of a first color, and the second type of pixels comprising a second sub-pixel of the first color, the display panel further comprising:
a substrate, the first type of pixels and the second type of pixels being provided on a side of the substrate;
a dimming structure, disposed at least partially on a side of the first type of pixels facing away from the substrate,
wherein an orthographic projection area on the substrate of the second sub-pixel is larger than an orthographic projection area on the substrate of the first sub-pixel, and a light extracting efficiency of the first sub-pixel is greater than a light extracting efficiency of the second sub-pixel.

2. The display panel according to claim 1, comprising:
a pixel defining layer located on a side of the substrate, the pixel defining layer comprising a pixel defining portion, and a first pixel opening and a second pixel opening each enclosed by the pixel defining portion and spaced apart,
wherein the first sub-pixel comprises a first light-emitting portion located at the first pixel opening, and the second sub-pixel comprises a second light-emitting portion located at the second pixel opening, an orthographic projection area on the substrate of the second pixel opening being larger than an orthographic projection area on the substrate of the first pixel opening.

3. The display panel according to claim 1, wherein the dimming structure comprises a filtering layer comprising a first filtering portion and a second filtering portion, an orthographic projection on the substrate of the first filtering portion overlapping with an orthographic projection on the substrate of the first sub-pixel, an orthographic projection on the substrate of the second filtering portion overlapping with an orthographic projection on the substrate of the second sub-pixel, and
a thickness of the first filtering portion being less than a thickness of the second filtering portion.

4. The display panel according to claim 3, wherein the first filtering portion is connected to the second filtering portion, and the filtering layer has a first surface facing away from the substrate and a concave portion formed by recessing inward from the first surface, an orthographic projection on the substrate of the concave portion overlapping with the orthographic projection on the substrate of the first filtering portion.

5. The display panel according to claim 3, wherein the dimming structure further comprises a light shielding layer comprising a first light shielding opening and a second light shielding opening that are spaced apart, the first filtering portion being disposed in the first light shielding opening, and the second filtering portion being at least partially provided in the second light shielding opening; and
the second filtering portion is provided to partially extend beyond a surface of the light shielding layer facing away from the substrate.

6. The display panel according to claim 5, wherein a distance between an orthographic projection on the substrate of the second light shielding opening and that of the second sub-pixel is greater than a distance between an orthographic projection on the substrate of the first light shielding opening and that of the first sub-pixel.

7. The display panel according to claim 5, wherein a refractive index of the filtering layer is greater than a refractive index of the light shielding layer.

8. The display panel according to claim 1, wherein the dimming structure comprises a light-adjusting layer configured to change propagation directions of light rays emitted by the first sub-pixel and the second sub-pixel.

9. The display panel according to claim 8, wherein the light-adjusting layer comprises a low-refractive index layer and a high-refractive index layer that are stacked, a refractive index of the high-refractive index layer being greater than a refractive index of the low-refractive index layer.

10. The display panel according to claim 9, wherein the low-refractive index layer comprises a first low-refraction opening corresponding to the first sub-pixel and a second low-refraction opening corresponding to the second sub-pixel, the high-refractive index layer at least partially filling the first low-refraction opening and the second low-refraction opening.

11. The display panel according to claim 10, wherein a distance between an orthographic projection on the substrate of the second low-refraction opening and that of the second sub-pixel is greater than a distance between an orthographic projection on the substrate of the first low-refraction opening and that of the first sub-pixel.

12. The display panel according to claim 11, wherein a distance between the orthographic projection on the substrate of the first low-refraction opening and that of the first sub-pixel is L1, and a distance between the orthographic projection on the substrate of the second low-refraction opening and that of the second sub-pixel is L2, where L1 and L2 satisfy: 0≤L1≤1µm, 1µm≤L2.

13. The display panel according to claim 10, wherein the high-refractive index layer partially extends beyond a surface of the low-refractive index layer facing away from the substrate, and the high-refractive index layer comprises a second surface facing away from the substrate, the second surface being a flat surface.

14. The display panel according to claim 9, wherein the high-refractive index layer comprises a first high-refraction portion and a second high-refraction portion that are spaced apart, an orthographic projection on the substrate of the first high-refraction portion overlapping with that of the first sub-pixel, an orthographic projection on the substrate of the second high-refraction portion overlapping with that of the second sub-pixel, and the low-refractive index layer covering outer surfaces of the first high-refraction portion and the second high-refraction portion.

15. The display panel according to claim 14, wherein a distance between an orthographic projection on the substrate of an outer contour of the second high-refraction portion and that of an outer contour of the second sub-pixel is greater than a distance between an orthographic projection on the substrate of an outer contour of the first high-refraction portion and that of an outer contour of the first sub-pixel.

16. The display panel according to claim 14, wherein the first high-refraction portion comprises a third surface facing away from the substrate, the low-refractive index layer being provided in contact with the third surface, the third surface comprising an arc-shaped structure and protruding in a direction away from the substrate.

17. The display panel according to claim 14, wherein the first high-refraction portion comprises a first side surface and a second side surface opposite to each other in a first direction, the first side surface comprising an arc-shaped structure and protruding in a direction away from the second side surface, the first direction being parallel to a plane where the substrate is located; and
the low-refractive index layer is provided in contact with the first side surface.

18. The display panel according to claim 14, wherein the low-refractive index layer partially extends beyond the surfaces of the first high-refraction portion and the second high-refraction portion facing away from the substrate, and the low-refractive index layer comprises a fourth surface facing away from the substrate, the fourth surface being a flat surface.

19. The display panel according to claim 9, wherein a material of the high-refractive index layer comprises at least one of zirconium oxide, hafnium oxide, tantalum oxide, niobium oxide, titanium oxide, yttrium oxide, silicon nitride, strontium titanate, tungsten oxide or chromium oxide;
and/or, a material of the low-refractive index layer comprises at least one of quartz, fused quartz, fluorine-doped fused quartz, magnesium fluoride, calcium fluoride, aluminum fluoride or ytterbium fluoride.

20. The display panel according to claim 1, wherein the first sub-pixel surrounds the second sub-pixel; or
the first sub-pixel and the second sub-pixel are disposed side by side.

21. The display panel according to claim 1, wherein the first type of pixels comprises a first electrode, a first light-emitting portion and a second electrode that are stacked sequentially in a direction away from the substrate, and the second type of pixels comprises a third electrode, a second light-emitting portion and a fourth electrode that are stacked sequentially in a direction away from the substrate,
wherein the first electrode and the third electrode are spaced apart, and/or, the second electrode and the fourth electrode are spaced apart.

22. The display panel according to claim 20, wherein the display panel has at least a first working mode and a second working mode, and in the first working mode, the first type of pixels emit light and the second type of pixels do not emit light, and in the second working mode, both the first type of pixels and the second type of pixels emit light;
and/or, the display panel has at least the first working mode and a third working mode, and in the third working mode, the first type of pixels do not emit light and the second type of pixels emit light.

23. A display device, comprising the display panel according to any one of claims 1 to 22.

24. A vehicle, comprising the display device according to claim 23.
